# EUROPEAN PATENT SPECIFICATION

(11) **EP 2 798 096 B1**
(45) Date of publication and mention of the grant of the patent: **03.07.2019**
(21) Application number: 12812497.1
(22) Date of filing: 26.12.2012
(51) Int. Cl.: C23C 14/02, C23C 14/20, C23C 14/58, C23C 28/02

(54) **METALLIZATION OF FLUOROELASTOMER FILMS**
METALLISIERUNG VON FLUOROELASTOMERFILMEN
MÉTALLISATION DE FILMS À BASE D'ÉLASTOMÈRE FLUORÉ

(30) Priority: 29.12.2011 US 201161581387 P
(43) Date of publication of application: 05.11.2014
(73) Proprietor: 3M Innovative Properties Company, St. Paul, MN 55133-3427 (US)
(72) Inventor: NESMITH, Gene B., Saint Paul, Minnesota 55133-3427 (US); YU, Steven Y., Saint Paul, Minnesota 55133-3427 (US)
(74) Representative: Vossius & Partner Patentanwälte Rechtsanwälte mbB
(86) International application number: PCT/US2012/071642
(87) International publication number: WO 2013/101822

(56) References cited:
- EP-A2- 0 363 093
- WO-A1-94/18003
- GB-A- 2 410 504

## Description

### Field of the Disclosure

This disclosure relates to fluoroelastomer materials and in particular films bearing a conductive metal layer bound to the fluoroelastomer material through a thin layer of titanium.

### Summary of the Disclosure

Briefly, the present disclosure provides a metalized fluoroelastomer material comprising: a) a fluoroelastomer material, bearing b) a layer of titanium metal in direct contact with the fluoroelastomer, and thereupon c) a first metal overlayer in direct contact with the layer of titanium metal, wherein the first metal overlayer comprises a metal selected from the group consisting of copper, noble metals and combinations thereof. In some embodiments, the fluoroelastomer material is a film having a thickness of between 1 µm and 1 millimeter. In some embodiments, the fluoroelastomer material is a perfluorinated fluoroelastomer material. The layer of titanium metal has a thickness of between 0.5 and 5.0 nm. In some embodiments, the first metal overlayer comprises a metal selected from alloys of copper, silver and gold. In some embodiments, the first metal overlayer is an alloy of copper. In some embodiments, the metalized fluoroelastomer material additionally comprises a metal top layer in direct contact with the metal overlayer having a thickness of at least 2 µm.

In another aspect, the present disclosure provides a method of making a metalized fluoroelastomer material comprising the steps of: a) providing a fluoroelastomer material; b) applying a layer of titanium metal to the fluoroelastomer material by a vapor coating method; and thereafter c) applying a metal overlayer to the fluoroelastomer material by a vapor coating method. In some embodiments, the method additionally comprises, prior to step b), the step of: d) exposing the fluoroelastomer material to an oxygen plasma. In some embodiments, the method additionally comprising, after step c), the step of: e) electroplating the fluoroelastomer material with a metal top layer.

As used herein with regard to a film, "thickness" means average thickness measured orthogonal to the plane of film, regardless of any patterning of the film, and where appropriate may be taken to be the nominal thickness of a film used in the practice of the present disclosure before patterning.

### Detailed Description

The present disclosure provides metalized fluoroelastomer materials such as fluoroelastomer films and methods of applying metal layers to fluoroelastomer materials.

Metalized plastic materials are already known in the prior art as illustrated by document GB 2410504 A, which describes a metalized plastic material, e.g. a fluororubber, bearing a layer of titanium metal in direct contact with it, and thereupon a first metal overlayer in direct contact with said layer of titanium. The use of a thin metal primer layer to improve the adhesion of a reflective metal layer on a polycarbonate substrate is also known from document EP 363093 A2.

The metalized fluoroelastomer materials according to the present disclosure may comprise any suitable fluoroelastomer. In some embodiments, the fluoroelastomer material is a fully cured polymer. In some embodiments, the fluoroelastomer material is a polymer of one or more of tetrafluoroethylene, hexafluoropropylene and vinylidene fluoride. In some embodiments, the fluoroelastomer material is perfluorinated. In some embodiments, the fluoroelastomer material is a film. In some embodiments, the film has a thickness of between 1 µm and 1 millimeter. In some embodiments, the film has a thickness of between 10 µm and 1 millimeter. In some embodiments, the film has a thickness of between 10 µm and 100 µm. In some embodiments, the film bears or is patterned with three-dimensional structural features. In some embodiments, the film bears or is patterned with three-dimensional structural features as described in one or more of U.S. Pat. Apps. Nos. 12/761162 and 12/761212.

The metalized surface of the fluoroelastomer material bears a layer of titanium in direct contact with the fluoroelastomer material and a first metal overlayer in direct contact with the titanium layer. The layer of titanium has a thickness of between 0.5 and 5.0 nm, typically between 1.0 and 3.0 nm. The first metal overlayer is copper, bronze, gold, a noble metal or a combination thereof. In some embodiments the first metal overlayer is copper or an alloy thereof. In some embodiments the first metal overlayer is copper. In some embodiments the first metal overlayer is gold or an alloy thereof. In some embodiments the first metal overlayer is gold. In some embodiments the first metal overlayer is silver or an alloy thereof. In some embodiments the first metal overlayer is silver. The metalized fluoroelastomer materials may optionally comprise a second metal overlayer which may be any suitable metal. In some embodiments, the second metal overlayer is copper, bronze, or another alloy of copper. In some embodiments the second metal overlayer is copper.

In some embodiments, the method according to the present invention comprises a first step of treatment with an oxygen plasma.

In some embodiments, the method according to the present invention comprises a second step of vapor coating with titanium, typically following after a first step of treatment with an oxygen plasma. In some embodiments, the second step of vapor coating with titanium is a step of sputter coating with titanium. In some embodiments, the second step of vapor coating with titanium is a step of evaporation coating with titanium.

In some embodiments, the method according to the present invention comprises a third step of vapor coating a first metal overlayer, typically following after a second step of vapor coating with titanium. In some embodiments, the third step of vapor coating with a first metal overlayer is a step of sputter coating with a first metal overlayer. In some embodiments, the third step of vapor coating with a first metal overlayer is a step of evaporation coating with a first metal overlayer. The first metal overlayer is copper, bronze, gold, a noble metal or a combination thereof. In some embodiments the first metal overlayer is copper or an alloy thereof. In some embodiments the first metal overlayer is copper. In some embodiments the first metal overlayer is gold or an alloy thereof. In some embodiments the first metal overlayer is gold. In some embodiments the first metal overlayer is silver or an alloy thereof. In some embodiments the first metal overlayer is silver. In some embodiments, the first metal overlayer has a thickness of between 20 nm and 2 µm. In some embodiments, the first metal overlayer has a thickness of between 100 nm and 500 nm.

In some embodiments, the method according to the present invention comprises a fourth step of applying a second metal overlayer, typically following after a third step of vapor coating a first metal overlayer. In some embodiments, the fourth step is a step of sputter coating with a second metal overlayer. In some embodiments, the fourth step is a step of evaporation coating with a second metal overlayer. In some embodiments, the fourth step is a step of electroplating with a second metal overlayer. The second metal overlayer may be any suitable metal. In some embodiments, the second metal overlayer is copper, bronze, or another alloy of copper. In some embodiments the second metal overlayer is copper. In some embodiments, the second metal overlayer has a thickness of between 20 nm and 2 µm. In some embodiments, the second metal overlayer has a thickness of between 100 nm and 500 nm.

In some embodiments, the method according to the present invention comprises a fifth step of applying a metal top layer, typically following after a third step of vapor coating a first metal overlayer. In some embodiments, the fifth step is a step of electroplating. The metal top layer may be any suitable metal. In some embodiments, the metal top layer is copper, bronze, or another alloy of copper. In some embodiments the metal top layer is copper. In some embodiments, the metal top layer has a thickness of between 20 nm and 2 µm. In some embodiments, the metal top layer has a thickness of greater than 2 µm. In some embodiments, the metal top layer has a thickness of greater than 5 µm. In some embodiments, the metal top layer has a thickness of greater than 10 µm.

The method of the present disclosure may be carried out using roll to roll vacuum processing techniques.

The disclosures of the following patent applications are cited as reference: WO 2010/07509 A, WO 2010/077849 A, WO 2010/121044 A and WO 2010/121058 A. Objects and advantages of this disclosure are further illustrated by the following examples, but the particular materials and amounts thereof recited in these examples, as well as other conditions and details, should not be construed to unduly limit this disclosure.

### Examples

Unless otherwise noted, all reagents were obtained or are available from Sigma-Aldrich Company, St. Louis, Missouri, or may be synthesized by known methods. Unless otherwise reported, all ratios are by weight percent.

The following abbreviations are used to describe the examples:
- A/ft²:: Amps per square foot
- A/m²:: Amps per square meter
- °F:: degrees Fahrenheit
- °C:: degrees Centigrade
- cm:: centimeters
- cm³/min.:: cubic centimeters per minute
- g/cm³:: grams per cubic centimeter
- kg:: kilograms
- kg/cm:: kilograms per centimeter
- kPa:: kilopascals
- kV:: kilovolts
- lbs/in.:: pounds per inch
- mA:: milliamps
- mil:: 10⁻³ inches
- mJ/cm²:: milliJoules per square centimeter
- mm:: millimeters
- µm:: micrometers
- W:: Watts

### Example.

A nominally 4 inch by 5 mil (10.16 cm by 127 µm) web of fluoroelastomer film comprising a non-perfluorinated THV polymer was subjected to an oxygen plasma pretreatment, followed by a titanium tie-coat and then a copper sputter coating according to the conditions listed in Table 1. A total of four replicates were made.

**TABLE 1**

| Conditions | Process Step | | |
|---|---|---|---|
| | Plasma PreTreatment | Titanium Tie-Coat | Copper Sputter |
| Gas | Oxygen | Argon | Argon |
| Gas Flow (cm³/min.) | 82 - 86 | 95 - 100 | 50 |
| Pressure (Pascals) | 4.0 | 2.67 | 0.67 |
| Power (W) | 100 - 200 | 500 - 600 | 500 - 1,000 |
| Voltage (kV) | 3 - 5 | 0.5 - 0.6 | 0.5 - 0.6 |
| Current (mA) | 25 - 30 | 1,000 | 1,000 - 2,000 |
| Web Speed (cm/min.) | 177.8 | 76.2 - 106.7 | 70.0 |
| Number of Passes | 1 | 1 | 2 - 6 |

Following copper sputtering, the sample was copper plated to a nominal thickness of 12 µm in a plating solution obtained under the trade designation "COPPER GLEAM CLX" from Dow Chemical Company, Midland, Michigan, for 28 minutes at 70°F (21.1°C) and 20 A/ft² (1.86 A/m²). After copper plating, the sample was rinsed with deionized water, dried using compressed air, immersed in a 10% by volume sulfuric acid/3% by volume hydrogen peroxide solution for 30 seconds, and again rinsed with deionized water and dried with compressed air. The sample was then laminated to a dry photoresist film, obtained under the trade designation "WBR 2050" from E.I. DuPont de Nemours and Company, Wilmington, Delaware, using a model "XRL 120" laminator from Western Magnum Corporation, El Segundo, California, at a roller temperature of 200°F (93.3°C) and 3 ft/min. (0.91 m/min). A 16 mil (0.41 mm) line photomask was placed over the photoresist film, exposed at 340 mJ/cm², developed in a "KEPRO" model bench top spray developer containing a 1%/0.1% by weight sodium carbonate/sodium bicarbonate solution for 5 minutes at 70°F (21.1°C), after which the sample was rinsed for 1 minute in deionized water and dried using compressed air. The sample was then etched for 6 minutes at 50°C in a 1.6 Molar copper (II) chloride dehydrate in 1.0 Molar hydrochloric acid solution, rinsed for 1 minute in deionized water and dried using compressed air. After etching, the photoresist was removed by immersing the sample in a 4% by weight potassium hydroxide solution for 3 minutes at 50°C, rinsing in deionized water for one minute and drying with compressed air.

### Peel Adhesion Test.

The force required to peel the test material from a substrate at an angle of 90 degrees was measured according to The Institute for Printed Circuits Test Method No. IPS-TM-650 No. 2.4.9.

The non-metal side of the fluoroelastomer film was glued to a microscope slide using an epoxy adhesive, obtained under the trade designation "SCOTCH-WELD EPOXY ADHESIVE 2216" from 3M Company, St. Paul, Minnesota. One edge of the copper layer was lifted off the microscope slide using a scalpel and attached to the jaws of the peel strength instrument, model "INSTRON 5567" from Illinois Tool Works, Inc., Glenview, Illinois. Peel strength was then measured three times per example with a 10 Newton load cell. Results are listed in Table 2.

**TABLE 2**

| Fluoroelastomer Example | Peel Strength |
|---|---|
| | lbs/in. (kg/cm) |
| Example 1 | 2.958 (0.528) |
| Example 2 | 2.705 (0.483) |
| Example 3 | 2.965 (0.529) |
| Example 4 | 2.831 (0.506) |

Various modifications and alterations of this disclosure will become apparent to those skilled in the art without departing from the scope of this disclosure, and it should be understood that this disclosure is not to be unduly limited to the illustrative embodiments set forth hereinabove.

## Claims

1. A metalized fluoroelastomer material comprising:
a) a fluoroelastomer material, bearing
b) a layer of titanium metal in direct contact with the fluoroelastomer, and thereupon
c) a first metal overlayer in direct contact with the layer of titanium metal,
wherein the first metal overlayer comprises a metal selected from the group consisting of copper, noble metals and combinations thereof,
wherein the layer of titanium metal has a thickness of between 0.5 and 5.0 nm.

2. The metalized fluoroelastomer material according to claim 1 wherein the fluoroelastomer material is a film having a thickness of between 1 µm and 1 millimeter.

3. The metalized fluoroelastomer material according to claim 1 or claim 2 wherein the fluoroelastomer material is a perfluorinated fluoroelastomer material.

4. The metalized fluoroelastomer material according to any of the preceding claims wherein the first metal overlayer comprises a metal selected from alloys of copper, silver and gold.

5. The metalized fluoroelastomer material according to any of the preceding claims wherein the first metal overlayer is an alloy of copper.

6. The metalized fluoroelastomer material according to any of the preceding claims additionally comprising a metal top layer in direct contact with the metal overlayer having a thickness of at least 2 µm.

7. A method of making a metalized fluoroelastomer material comprising the steps of:
a) providing a fluoroelastomer material;
b) applying a layer of titanium metal to the fluoroelastomer material by a vapor coating method; and thereafter
c) applying a metal overlayer to the fluoroelastomer material by a vapor coating method,
wherein the layer of titanium metal has a thickness of between 0.5 and 5.0 nm.

8. The method according to claim 7 additionally comprising, prior to step b), the step of:
d) exposing the fluoroelastomer material to an oxygen plasma.

9. The method according to claim 7 or 8 additionally comprising, after step c), the step of:
e) electroplating the fluoroelastomer material with a metal top layer.

10. The method according to any of claims 7 to 9 wherein the fluoroelastomer material is a film having a thickness of between 1 µm and 1 millimeter.

11. The method according to any of claims 7 to 10 wherein the fluoroelastomer material is a perfluorinated fluoroelastomer material.

12. The method according to any of claims 7 to 11 wherein the first metal overlayer comprises a metal selected from alloys of copper, silver and gold.

13. The method according to any of claims 7 to 11 wherein the first metal overlayer is an alloy of copper.

## Patentansprüche

1. Metallisiertes Fluorelastomermaterial, das umfasst:
a) ein Fluorelastomermaterial, das Folgendes trägt:
b) eine Schicht aus Titanmetall in direktem Kontakt mit dem Fluorelastomer, und darauf
c) eine erste Metallüberschicht in direktem Kontakt mit der Schicht aus Titanmetall, wobei die erste Metallüberschicht ein Metall umfasst, das ausgewählt ist aus der Gruppe bestehend aus Kupfer, Edelmetallen und Kombinationen davon,
wobei die Schicht aus Titanmetall eine Dicke zwischen 0,5 und 5,0 nm aufweist.

2. Metallisiertes Fluorelastomermaterial nach Anspruch 1, wobei das Fluorelastomermaterial eine Folie mit einer Dicke zwischen 1 µm und 1 Millimeter ist.

3. Metallisiertes Fluorelastomermaterial nach Anspruch 1 oder Anspruch 2, wobei das Fluorelastomermaterial ein perfluoriertes Fluorelastomermaterial ist.

4. Metallisiertes Fluorelastomermaterial nach einem der vorstehenden Ansprüche, wobei die erste Metallüberschicht ein Metall umfasst, das ausgewählt ist aus Legierungen von Kupfer, Silber und Gold.

5. Metallisiertes Fluorelastomermaterial nach einem der vorstehenden Ansprüche, wobei die erste Metallüberschicht eine Kupferlegierung ist.

6. Metallisiertes Fluorelastomermaterial nach einem der vorstehenden Ansprüche, zusätzlich umfassend eine Metalldeckschicht in direktem Kontakt mit der Metallüberschicht mit einer Dicke von mindestens 2 µm.

7. Verfahren zum Herstellen eines metallisierten Fluorelastomermaterials, das die Schritte umfasst:
a) Bereitstellen eines Fluorelastomermaterials;
b) Aufbringen einer Schicht aus Titanmetall auf das Fluorelastomermaterial durch ein Dampfbeschichtungsverfahren; und anschließend
c) Aufbringen einer Metallüberschicht auf das Fluorelastomermaterial durch ein Dampfbeschichtungsverfahren,
wobei die Schicht aus Titanmetall eine Dicke zwischen 0,5 und 5,0 nm aufweist.

8. Verfahren nach Anspruch 7, ferner umfassend, vor Schritt b), den Schritt:
d) Aussetzen des Fluorelastomermaterials gegenüber einem Sauerstoffplasma.

9. Verfahren nach Anspruch 7 oder 8, ferner umfassend, nach Schritt c) den Schritt:
e) Elektroplattieren des Fluorelastomermaterials mit einer Metalldeckschicht.

10. Verfahren nach einem der Ansprüche 7 bis 9, wobei das Fluorelastomermaterial eine Folie ist, die eine Dicke zwischen 1 µm und 1 Millimeter aufweist.

11. Verfahren nach einem der Ansprüche 7 bis 10, wobei das Fluorelastomermaterial ein perfluoriertes Fluorelastomermaterial ist.

12. Verfahren nach einem der Ansprüche 7 bis 11, wobei die erste Metallüberschicht ein Metall umfasst, das aus Legierungen von Kupfer, Silber und Gold ausgewählt ist.

13. Verfahren nach einem der Ansprüche 7 bis 11, wobei die erste Metallüberschicht eine Kupferlegierung ist.

## Revendications

1. Matériau fluoroélastomère métallisé comprenant :
a) un matériau fluoroélastomère, portant
b) une couche de titane métallique en contact direct avec le fluoroélastomère et, sur celle-ci
c) une première surcouche métallique en contact direct avec la couche de titane métallique, la première surcouche métallique comprenant un métal choisi dans le groupe constitué par le cuivre, les métaux nobles et leurs combinaisons,
la couche de titane métallique présentant une épaisseur située entre 0,5 et 5,0 nm.

2. Matériau fluoroélastomère métallisé selon la revendication 1, le matériau fluoroélastomère étant un film présentant une épaisseur située entre 1 µm et 1 mm.

3. Matériau fluoroélastomère métallisé selon la revendication 1 ou la revendication 2, le matériau fluoroélastomère étant un matériau fluoroélastomère perfluoré.

4. Matériau fluoroélastomère métallisé selon l'une quelconque des revendications précédentes, la première surcouche métallique comprenant un métal choisi parmi les alliages de cuivre, d'argent et d'or.

5. Matériau fluoroélastomère métallisé selon l'une quelconque des revendications précédentes, la première surcouche métallique étant un alliage de cuivre.

6. Matériau fluoroélastomère métallisé selon l'une quelconque des revendications précédentes, comprenant en outre une couche supérieure métallique en contact direct avec la surcouche métallique, présentant une épaisseur d'au moins 2 µm.

7. Procédé de fabrication d'un matériau fluoroélastomère métallisé, comprenant les étapes :
a) mise à disposition d'un matériau fluoroélastomère ;
b) application d'une couche de titane métallique sur le matériau fluoroélastomère par un procédé de revêtement en phase vapeur ; et ensuite
c) application d'une surcouche métallique sur le matériau fluoroélastomère par un procédé de revêtement en phase vapeur,
la couche de titane métallique présentant une épaisseur située entre 0,5 et 5,0 nm.

8. Procédé selon la revendication 7, comprenant en outre, avant l'étape b), l'étape :
d) exposition du matériau fluoroélastomère à un plasma d'oxygène.

9. Procédé selon la revendication 7 ou 8, comprenant en outre, après l'étape c), l'étape :
e) recouvrement par dépôt électrolytique du matériau fluoroélastomère d'une couche supérieure métallique.

10. Procédé selon l'une quelconque des revendications 7 à 9, le matériau élastomère étant un film présentant une épaisseur située entre 1 µm et 1 millimètre.

11. Procédé selon l'une quelconque des revendications 7 à 10, le matériau fluoroélastomère étant un matériau fluoroélastomère perfluoré.

12. Procédé selon l'une quelconque des revendications 7 à 11, la première surcouche métallique comprenant un métal choisi parmi les alliages de cuivre, d'argent et d'or.

13. Procédé selon l'une quelconque des revendications 7 à 11, la première surcouche métallique étant un alliage de cuivre.
